# EUROPÄISCHE PATENTSCHRIFT

(11) **EP 0 886 997 B1**
(45) Veröffentlichungstag und Bekanntmachung des Hinweises auf die Patenterteilung: **06.10.1999**
(21) Anmeldenummer: 97915319.4
(22) Anmeldetag: 28.02.1997
(51) Int. Cl.: H05K 9/00, H05K 7/14

(54) **ELEKTROMAGNETISCH ABGESCHIRMTES GEHÄUSE MIT ÜBER EINE KONTAKTFEDERLEISTE VERRASTBAREN METALLISCHEN GEHÄUSETEILEN**
CASING SCREENED FROM ELECTROMAGNETIC WAVES AND HAVING METAL CASING PARTS LOCKABLE BY A SPRING CONTACT STRIP
BOITIER A BLINDAGE ELECTROMAGNETIQUE AVEC ELEMENTS DE BOITIER METALLIQUES VERROUILLABLES PAR UNE REGLETTE DE CONTACTS A RESSORTS

(30) Priorität: 12.03.1996 DE 29604599 U
(43) Veröffentlichungstag der Anmeldung: 30.12.1998
(73) Patentinhaber: SIEMENS AKTIENGESELLSCHAFT, 80333 München (DE)
(72) Erfinder: KURRER, Siegfried, D-90449 Nürnberg (DE); KÖRBER, Werner, D-91282 Betzenstein (DE); BILLENSTEIN, Ernst, D-91593 Burgbernheim (DE); SCHAFFER, Kurt-Michael, D-90542 Eckental (DE)
(86) Internationale Anmeldenummer: DE9700369
(87) Internationale Veröffentlichungsnummer: WO9734456

(56) Entgegenhaltungen:
- DE-U- 9 209 519
- DE-U- 9 402 714
- DE-U- 29 618 628
- DE-U- 29 618 631

## Beschreibung

Um eine störungsfreie Funktion von elektrischen Schaltungen und dergleichen gewährleisten zu können, ist es notwendig, diese gegen elektromagnetische Wellen abzuschirmen. Hierzu muß das Gehäuse, welches die elektrische Schaltung umgibt überwiegend aus metallischen Gehäuseteilen bestehen. Dabei verhindert die Abschirmung sowohl ein Eindringen von elektromagnetischen Wellen, als auch deren Austreten aus dem Gehause. Hierzu ist es erforderlich, daß zwischen den metallischen Gehäuseteilen durchgehend elektrisch leitende Verbindungen, insbesondere über Kontaktfederelemente, hergestellt werden. Abhängig von der Höhe der elektromagnetischen Frequenzen müssen diese Verbindungen möglichst lückenlos sein.

Aus dem Dokument G 92 09 519.4 ist ein HF-dichter Baugruppenträger bekannt. Dieser weist eine Abdeckung mit vorn und hinten abgewinkelten Randleisten auf. Bei montierter Abdeckung greifen diese in Längsrillen zweier oberer Modulschienen ein. In jede der Längsrillen ist dabei ein bandförmiges Federelement eingeschoben, welches bei montierter und mit Befestigungsschrauben an die oberen Modulschienen angeschraubter Abdeckung einen elektrischen Kontakt zwischen Modulschienen und Abdeckung herstellt.

Nachteilig ist die prinzipielle Trennung von elektrischer und mechanischer Verbindung zwischen Modulschienen und Abdeckung, welche die Montage der Abdeckung erschwert. Während die elektrische Verbindung durch die in die Längsrillen greifenden abgewinkelten Randleisten der Abdeckung hergestellt wird, erfolgt die mechanische Verbindung in jedem Fall durch Verschraubung.

Aus dem Dokument DE 39 28 461 C2 ist ein elektromagnetisch abgeschirmter Baugruppenträger bekannt. Dieser weist insbesondere metallische Abdeckplatten mit an allen vier Seiten abgewinkelten Rändern auf. Desweiteren sind im Baugruppenträger Profilschienen mit Nuten angebracht, welche an einem Rand einen leistenförmigen Vorsprung aufweisen. In diese Nuten sind V-förmige Federn eingesetzt, die sich nahezu über die gesamte Nutlänge erstrecken. Die abgewinkelten Ränder einer Abdeckplatte, die in der Breite des Baugruppenträgers verlaufen, werden bei der Montage in die Nuten eingedrückt. Dabei drücken die abgewinkelten Ränder gegen die Schenkel der Federn und erzeugen eine elektrisch leitende Verbindung zwischen Abdeckplatte und Profilschienen. An denjenigen Enden der Abdeckplatten, die sich in Richtung der Seitenwände erstrecken, liegen die abgewinkelten Ränder an den Innenseiten der Seitenwände auf. Durch in den Seitenwänden in der Hohe der Ränder angebrachte Bohrungen sind diese mit den Rändern der Abdeckplatten mechanisch verschraubbar und zu einer elektrisch leitenden Verbindung zusammendrückbar.

Ein Problem stellt bei der Montage des Baugruppenträgers der durch die V-förmigen Federn ausgeübte Gegendruck auf die abgewinkelten Ränder der Abdeckplatte dar. So werden diese Randbereiche der Abdeckplatte nach oben gebogen und müssen in einer aufwendigen Weise zur Montage zusätzlich auf die Profilschienen aufgedrückt werden. Eine anschließende Verschraubung der Abdeckplatte mit den Seitenwänden ist somit nicht vermeidbar. Desweiteren läßt sich nicht verhindern, daß die abgewinkelten Ränder trotz der Verschraubung der Abdeckplatte durch die Federn nach oben gebogen werden und unter Umständen geringfügig hervorstehen. Hierdurch kann sich gegebenenfalls eine unerwünschte dauerhafte Verbiegung der Abdeckplatte und eine Beeinträchtigung der elektromagnetischen Abschirmung ergeben.

Des weiteren ist aus dem Dokument DE 94 02 714 U1 ein Baugruppenträger mit Profilleisten und mit Deckplatten bekannt. Die Deckplatten sind über Nietverbindungen Schnappfedern befestig, wobei die Schnappfedern an den Profilleisten verrastbar sind. Zur elektromagnetischen Abdichtung zwischen Deckplatten und Profilleisten sind an den Profilleisten zusätzlich Dichtelemente in Form von mit Metallfolie umwickelten Schaumstoffdichtungen befestigt.

Der Erfindung liegt die Aufgabe zugrunde ein elektromagnetisch abgeschirmtes Gehäuse, insbesondere einen Baugruppenträger, anzugeben, welches eine einfachere Montage der metallischen Gehäuseteile ermöglicht.

Die Aufgabe wird gelöst mit einem elektromagnetisch abgeschirmten Gehäuse gemäß dem Anspruch 1.

Vorteil des Gehäuses gemäß der Erfindung ist die erleichterte Montage von Gehäuseteilen, beispielsweise den Abdeckplatten eines Baugruppenträgers. Das mittels der Kontaktfederleiste bewirkte Verrasten zweier Gehäuseteile erfordert kein zusätzliches Zusammendrücken. Desweiteren ist eine zusätzliche Verschraubung nicht notwendig. Soll andernfalls dennoch eine Verschraubung erfolgen, so kann diese in die spannungsfrei in der Endlage fixierten Gehäuseteile eingebracht werden.

Besonders vorteilhaft ist es, daß beispielsweise bei einem Baugruppenträger als abgeschirmtes Gehäuse die Ränder von Abdeckplatten aus der Federnut einer Querschiene nach einem Eindrücken gemäß der Erfindung nicht wieder zurückgebogen werden, sondern vielmehr in dieser fest verrastet sind. Dies ermöglicht somit eine optimale elektromagnetische Abschirmung auch im Übergangsbereich zwischen Gehäuseteilen.

Weitere vorteilhafte Ausführungsformen der Erfindung sind in den entsprechenden Unteransprüchen angegeben.

Die Erfindung wird desweiteren anhand des in den nachfolgend kurz angeführten Figuren dargestellten Ausführungsbeispieles weiter erläutert. Dabei zeigt
- FIG 1: beispielhaft die Seitenansicht eines Gehäuses gemäß der Erfindung mit einem ersten Gehäuseteil mit aufgesteckter Kontaktfederleiste und einem zweiten Gehäuseteil,
- FIG 2: beispielhaft die Seitenansicht des Gehäuses gemäß Figur 1, wobei das erste Gehäuseteil mittels der aufgesteckten Kontaktfederleiste mit dem zweiten Gehäuseteil kontaktiert und verrastet ist,
- FIG 3: beispielhaft den vorderen Eckbereich eines Baugruppenträgers, wobei ein Etagenschirmblech gemäß der Erfindung mit einer vorderen Querschiene kontaktierbar und verrastbar ist, und
- FIG 4: beispielhaft eine Seitenansicht des in Figur 3 dargestellten Gehäuses, wobei ein erstes Gehäuseteil gemäß der Erfindung mittels einer Kontaktfederleiste mit einem zweiten Gehäuseteil kontaktiert und verrastet ist und das erste Gehäuseteil im Bereich der Seitenkanten zusätzlich von Auflageelementen abgestützt ist.

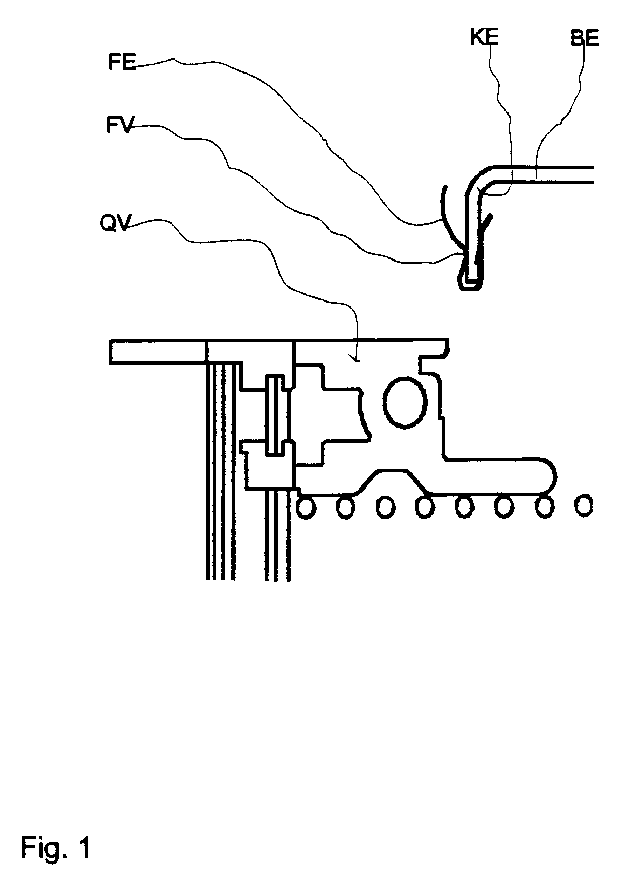

In Figur 1 ist beispielhaft ein gemäß der Erfindung gestaltetes erstes metallisches Gehäuseteil BE, sowie ein zweites metallisches Gehäuseteil QV eines elektromagnetisch abgeschirmten Gehäuses gemäß der Erfindung dargestellt. In der beispielhaften Seitenansicht ist das erste Gehäuseteil BE noch nicht auf das zweite Gehäuseteil QV aufgesetzt und stellt den Zustand vor der Montage der beiden Gehäuseteile BE, QV dar. Dabei ist das erste Gehäuseteil BE mit wenigstens einer Kontaktfederleiste FE versehen. Die Verbindung zwischen dem ersten Gehäuseteil BE und der Kontaktfederleiste FE beruht dabei vorwiegend auf Verrastung oder Verklemmung.

In einer Ausführungsform des erfindungsgemäßen, elektromagnetisch abgeschirmten Gehäuses weist das erste Gehäuseteil BE einen bevorzugt abgewinkelten Randbereich KE auf, mit dem die Kontaktfederleiste FE verbunden ist. Dieser bevorzugt abgewinkelte Randbereich KE stellt insbesondere einen Kontaktschenkel dar und entsteht beispielsweise durch Abkantung des im vorliegenden Falle blechartigen ersten Gehäuseteils BE.

In einer weiteren Ausführungsform des erfindungsgemäßen, elektromagnetisch abgeschirmten Gehäuses weist die Kontaktfederleiste FE einen Verengungsbereich FV auf, über den die Kontaktfederleiste FE mit dem ersten Gehäuseteil BE verklemmt ist. Beispielsweise ist dabei der Verengungsbereich FV so im Fußbereich der Kontaktfederleiste FE gestaltet, daß diese auf den Rand des ersten Gehäuseteils BE verklemmend aufsteckbar ist.

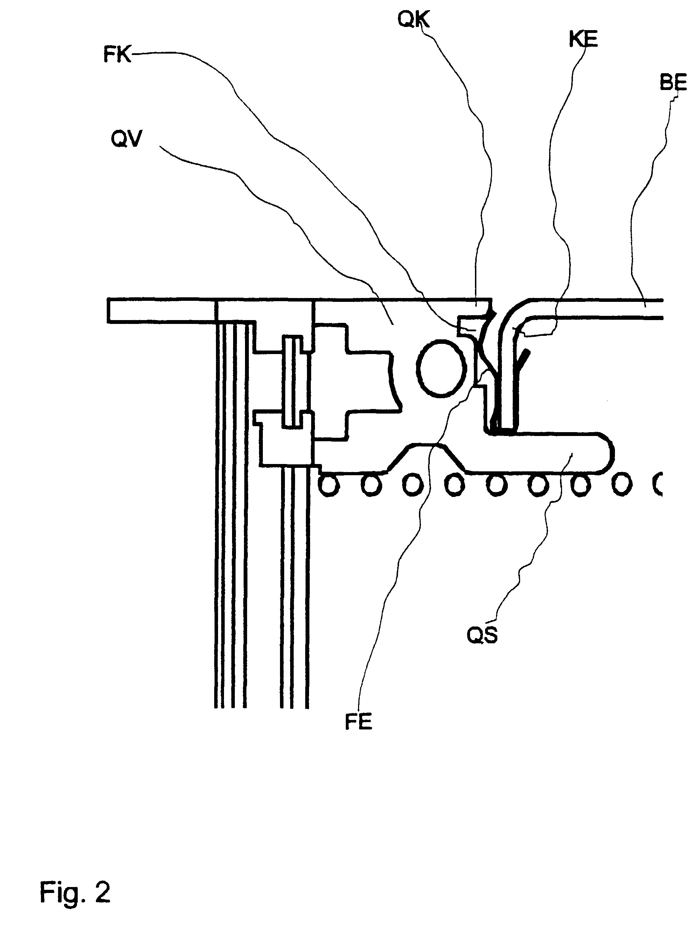

In Figur 2 ist die in Figur 1 dargestellte Seitenansicht des elektromagnetisch abgeschirmten Gehäuses gemäß der Erfindung nochmals dargestellt, wobei das erste Gehäuseteil BE über die Kontaktfederleiste FE mit dem zweiten metallischen Gehäuseteil QV gleichzeitig kontaktiert und verrastet ist. Die Verrastung erleichtert dabei vorteilhaft die Montage und verhindert eine unerwünschte Trennung der Gehäuseteile. Durch die federnd anliegende Kontaktfederleiste FE wird eine elektrisch gut leitende Verbindung zwischen dem ersten und dem zweiten Gehäuseteil BE, QV hergestellt und damit eine durchgehende elektromagnetische Abschirmung des Gehäuses bewirkt.

In einer Ausführungsform des erfindungsgemäßen, elektromagnetisch abgeschirmten Gehäuses weist die Kontaktfederleiste FE einen Kontaktbügel FK auf. Dieser ist derart abgespreizt, daß dieser federnd am zweiten Gehäuseteil QV anliegt und an diesem kontaktierbar und verrastbar ist. Im Beispiel der Figur 2 hintergreift der Kontaktbügel FK verrastend einen bevorzugt leistenförmigen Vorsprung QK des zweiten Gehäuseteils QV.

Desweiteren kann der bevorzugt leistenförmige Auflageschenkel QS des zweiten Gehäuseteils QV dazu dienen, das erste Gehäuseteil BE insbesondere im Bereich des abgewinkelten Randbereichs KE zu stützen.

In einer weiteren Ausführungsform der Erfindung ist das elektromagnetisch abgeschirmte Gehäuse als Baugruppenträger ausgebildet. Dabei kann als erstes Gehäuseteil ein Schirmblech BE, insbesondere ein Etagenschirmblech und als zweites Gehäuseteil eine Querschiene QV dienen. Die Breite des bevorzugt abgewinkelten Randbereichs KE des Etagenschirmblechs BE ist dabei dann insbesondere auf die Querschiene QV angepaßt, an der dieser mittels der Kontaktfederleiste FE verrastet.

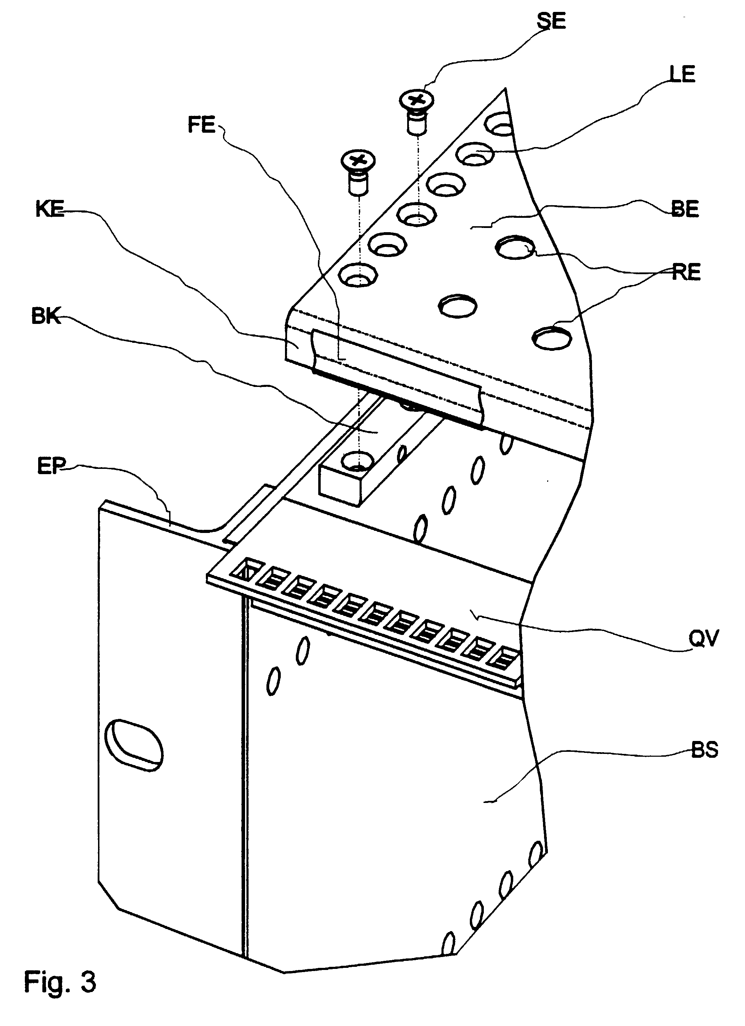

Die Figur 3 zeigt beispielhaft den vorderen Eckbereich eines derartigen Baugruppenträgers. Dieser weist zumindest ein oberes metallisches Etagenschirmblech BE mit abgewinkeltem Randbereich KE und wenigstens eine metallische vordere Querschiene QV auf. In der beispielhaften, perspektivischen Darstellung der Figur 3 ist die auf das Etagenschirmblech BE aufgeklemmte Kontaktfederleiste FE (Figur 1 und 2) prinzipiell abschnittsweise dargestellt. Das Etagenschirmblech BE befindet sich dabei noch nicht im verrasteten Zustand mit der vorderen Querschiene QV.

Im Ausführungsbeispiel der Figur 3 ist zusätzlich ein separates, innen liegendes Auflageelement BK dargestellt. Mit diesem Auflageelement BK oder einer Vielzahl davon wird eine eckstoßartige Verbindung des Etagenschirmblechs BE mit dem Seitenwandblech BS in deren Kantenbereich bewirkt. Dadurch wird insbesondere eine möglichst lückenlose elektromagnetische Abschirmung im Inneren des Baugruppenträgers erreicht. Bei dieser Verbindung erfolgt somit kein Überlappen zwischen Etagenschirmblech BE und Seitenwandblech BS. Deren entsprechende Seitenkanten stoßen nunmehr als Eckstoßverbindung aneinander und sind mit einem oder einer Vielzahl von Auflageelementen BK verbindbar. Dadurch ist insbesondere die Variabilität bezüglich der Positionierung von Auflageelementen BK besonders im Kantenbereich gegeben. Das oder die Auflageelemente BK können insbesondere auch für weitere Eckstoßverbindungen im Baugruppenträger dienen, wie beispielsweise zwischen einem möglichen weiteren, unteren Etagenschirmblech und weiteren Seitenwandblechen oder Vor- und/oder Rückwänden. Zum Verbinden von einem Etagenschirmblech BE, einem Seitenwandblech BS und einem Auflageelement BK hat sich insbesondere das Verschrauben mit Senkkopfschrauben SE als vorteilhaft erwiesen.

Desweiteren weist im Ausführungsbeispiel von Figur 3 der Baugruppenträger ein seitliches Eckprofil EP auf, welches mit einem Seitenwandblech BS des Baugruppenträgers und zumindest im oberen Eckbereich mit einer vorderen Querschiene QV verbunden ist. Das Etagenschirmblech BE weist insbesondere ein Lüftungslochraster RE auf, wodurch in den Baugruppenträger eingeführte Baugruppen belüftet werden können. Entsprechend der Symmetrie kann der Baugruppenträger insbesondere ein in der Figur 3 nicht dargestelltes mögliches unteres Etagenschirmblech BE, weitere Querschienen QV und ein weiteres Seitenwandblech BS oder Vor- und/oder Rückwände aufweisen. Beispielsweise zur Verschraubung mit Senkkopfschrauben SE weist das Etagenschirmblech BE jeweils eine Befestigungslochreihe LE zumindest im Seitenbereich der Kante bzw. Kanten auf, welche dem oder den Seitenwandblechen BS am nächsten liegen.

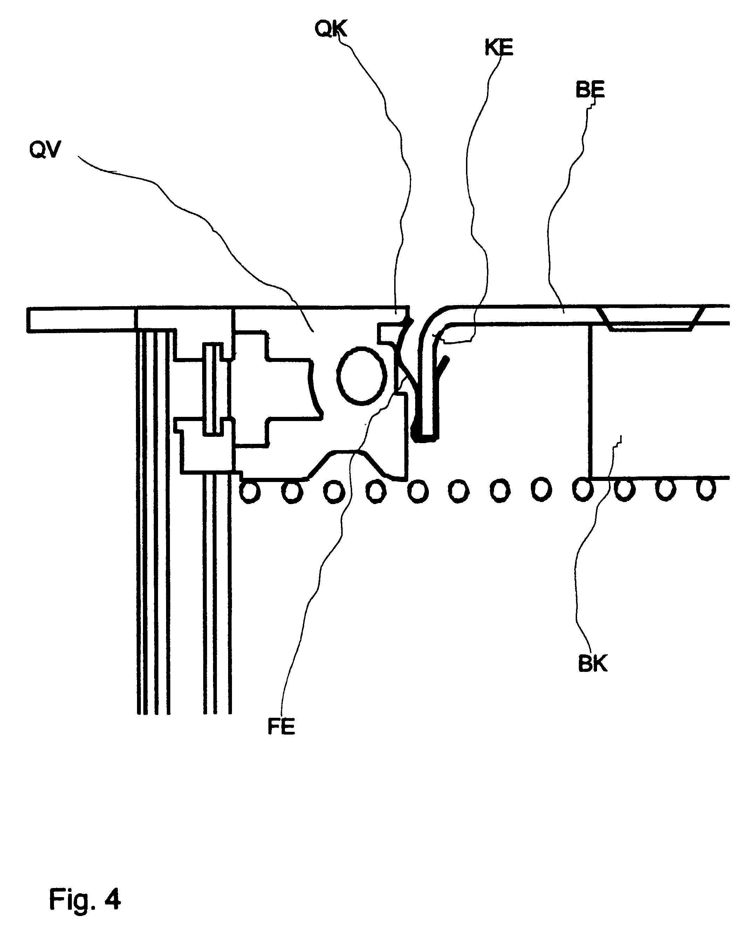

Figur 4 stellt beispielhaft eine Seitenansicht im Eckbereich des in der Figur 3 dargestellten Baugruppenträgers dar, wobei ein erstes Gehäuseteil BE mit einem zweiten Gehäuseteil QV kontaktiert und verrastet ist. Dabei hintergreift eine mit dem bevorzugt abgewinkelten Randbereich KE des ersten Gehäuseteils BE verbundene Kontaktfederleiste FE verrastend einen bevorzugt leistenförmigen Vorsprung QK des zweiten Gehäuseteils QV. Zur Abstützung des ersten Gehäuseteils BE ist dieses im Bereich der nicht abgewinkelten Seitenkanten von Auflageelementen BK abgestützt.

Besonders vorteilhaft ist die Erfindung bei Baugruppenträgern als elektromagnetisch abgeschirmtes Gehäuse gemäß der Erfindung. Vorteilhaft ist dabei insbesondere die vereinfachte Montage der Etagenschirmbleche BE. Das über die Kontaktfederleiste FE bewirkte spannungsfreie Verrasten eines Etagenschirmblechs BE mit einer Querschiene QV erfordert kein zusätzliches Fixieren bzw. Zusammendrücken. Eine zusätzliche Verschraubung des Etagenschirmblechs BE mit Seitenwandblechen BS braucht nur dann zu erfolgen, wenn eine erhöhte Stabiliät erforderlich ist. Dafür eignet sich beispielsweise eine Verschraubung mittels vorteilhaften Auflageelementen BK oder mittels in der Figur 3 nicht dargestellten weiteren Abkantungen des seitlichen Randbereiches des Etagenschirmblechs BE. Besonders vorteilhaft ist desweiteren die durch die Verrastung bewirkte optimale elektromagnetische Abschirmung auch im Übergangsbereich zwischen Etagenschirmblechen BE und Querschienen QV.

## Patentansprüche

1. Elektromagnetisch abgeschirmtes Gehäuse, insbesondere ein Baugruppenträger, mit metallischen Gehäuseteilen und wenigstens einer Kontaktfederleiste (FE), welche aufweist
a) einen Verengungsbereich (FV), über den die Kontaktfederleiste (FE) mit einem ersten Gehäuseteil (BE) verklemmt ist, und
b) einen Kontaktbügel (FK), welcher derart abgespreizt ist, daß das erste Gehäuseteil (BE) mit einem zweiten metallischen Gehäuseteil (QV) gleichzeitig kontaktierbar und verrastbar ist.

2. Gehäuse nach Anspruch 1, wobei die Kontaktfederleiste (FE) mit einem Randbereich (KE) eines ersten Gehäuseteils (BE) verbunden ist.

3. Gehäuse nach Anspruch 2, wobei die Kontaktfederleiste (FE) mit einem abgewinkelten Randbereich (KE) eines ersten Gehäuseteils (BE) verbunden ist.

4. Gehäuse nach einem der vorangegangen Ansprüche, wobei das zweite Gehäuseteil (QV) einen Vorsprung (QK) aufweist, den der Kontaktbügel (FK) der Kontaktfederleiste (FE) verrastend hintergreift.

5. Gehäuse nach einem der vorangegangen Ansprüche, mit einem Schirmblech als erstes Gehäuseteil (BE), insbesondere einem Etagenschirmblech eines Baugruppenträgers.

6. Gehäuse nach einem der vorangegangen Ansprüche, mit einer Querschiene als zweites Gehäuseteil (QV), insbesondere einer Querschiene eines Baugruppenträgers.

7. Gehäuse nach einem der vorangegangen Ansprüche, wobei das erste metallische Gehäuseteil (BE) wenigstens eine nicht abgewinkelte Seitenkante aufweist, welche durch innen liegende Auflageelemente (BK) gestützt ist (Fig. 4).

## Claims

1. Electromagnetically screened housing, in particular a subrack, having metal housing parts and at least one contact socket connector (FE), which has
a) a constricted region (FV) via which the contact socket connector (FE) is jammed with a first housing part (BE), and
b) a contact bow (FK) which is spread out in such a way that the first housing part (BE) can simultaneously make contact with and be latched to a second metal housing part (QV).

2. Housing according to Claim 1, in which the contact socket connector (FE) is joined to an edge region (KE) of a first housing part (BE).

3. Housing according to Claim 2, in which the contact socket connector (FE) is joined to an angled-off edge region (KE) of a first housing part (BE).

4. Housing according to one of the preceding claims, in which the second housing part (QV) has a projection (QK) behind which the contact bow (FK) of the contact socket connector (FE) engages in a latching fashion.

5. Housing according to one of the preceding claims, having a screening plate as the first housing part (BE), in particular a laminate screening plate of a subrack.

6. Housing according to one of the preceding claims, having a transverse section as the second housing part (QV), in particular a transverse section of a subrack.

7. Housing according to one of the preceding claims, in which the first metal housing part (BE) has at least one side edge which is not angled off and which is supported by inwardly situated bearing elements (BK) (Figure 4).

## Revendications

1. Boîtier à blindage électromagnétique, notamment porte-module, compor-tant des pièces métalliques de boîtier et au moins une réglette (FE) de ressort de contact qui comporte
a) une zone (FV) de rétrécissement par l'intermédiaire de laquelle la réglette (FE) de ressort de contact est coincée sur une première pièce (BE) de boîtier et
b) un étrier (FK) de contact qui est écarté de manière que la première pièce (BE) de boîtier puisse être en même temps mise en contact et encliquetée avec une deuxième pièce (QV) métallique de boîtier.

2. Boîtier suivant la revendication 1, la réglette (FE) de ressort de contact étant reliée à une zone (KE) marginale d'une première pièce (BE) de boîtier.

3. Boîtier suivant la revendication 2, la réglette (FE) de ressort de contact étant reliée à une zone (KE) marginale coudée d'une première pièce (BE) de boîtier.

4. Boîtier suivant l'une des revendications précédentes, la deuxième pièce (QV) de boîtier comportant une partie (QK) en saillie qui s'accroche derrière l'étrier (FK) de contact de la réglette (FE) de ressort de contact en s'y encliquetant.

5. Boîtier suivant l'une des revendications précédentes, comportant une tôle de blindage comme première pièce (BE) de boîtier, notamment une tôle de blindage étagée d'un porte-module.

6. Boîtier suivant l'une des revendications précédentes, comportant un rail transversal comme deuxième pièce (QV) de boîtier, notamment un rail transversal d'un porte-module.

7. Boîtier suivant l'une des revendications précédentes, la première pièce (BE) métallique de boîtier comportant au moins un bord latéral non coudé qui est soutenu par des éléments (BK) de support se trouvant à l'intérieur (figure 4).
